# EUROPEAN PATENT SPECIFICATION

(11) **EP 2 093 243 B1**
(45) Date of publication and mention of the grant of the patent: **16.10.2013**
(21) Application number: 08163172.3
(22) Date of filing: 28.08.2008
(51) Int. Cl.: C08G 65/00

(54) **Electronic component including anti-oxide film and method for making the electronic component**
Elektronische Komponente mit Anti-Oxid-Film und Verfahren zur Herstellung der elektronischen Komponente
Composant électronique incluant un film anti-oxydant et procédé de formation du composant électronique

(30) Priority: 01.02.2008 KR 20080010651
(43) Date of publication of application: 26.08.2009
(73) Proprietor: Samsung Electronics Co., Ltd., Suwon-si, Gyeonggi-do, 443-742 (KR)
(72) Inventor: Hahn, Jung Seok, 449-712, Gyeonggi-do (KR); Seon, Jong Baek, 449-712, Gyeonggi-do (KR); Lee, Jong Ho, 449-712, Gyeonggi-do (KR); O, Min Ho, 449-712, Gyeonggi-do (KR); Hwang, Euk Che, 449-712, Gyeonggi-do (KR)
(74) Representative: Zijlstra, Robert Wiebo Johan

(56) References cited:
- EP-A- 1 231 297
- EP-A- 1 905 800
- EP-A- 2 040 121
- WO-A-99/14399

## Description

Subject-matter of the present invention are electronic compounds according to claims 1-10, and methods for preparing such electronic components according to claims 11 to 15.

Described herein is a composition, an anti-oxide film and electronic component including the same, and methods of forming an anti-oxide film and an electronic component.

Aluminum (Al) may be used as a material for wiring pads employed in memory and processing microdevices, but the intrinsic nature of aluminum allows for relatively low conductivity and relatively high processing costs, as compared to other metal materials. Copper (Cu) may exhibit improved electrical properties compared with other metal materials and may be relatively inexpensive. However, copper may have a higher degree of oxidation which consequently leads to difficulty in application thereof to conventional processes due to formation of an oxide film upon formation of a thin film. Therefore, research has been undertaken on development of an anti-oxide film for inhibiting or preventing formation of the oxide film of copper.

A conventional anti-oxide film inhibiting formation of the copper oxide film may be an anti-oxide film of a self-assembled monolayer (SAM) formed using an organic material. A conventional example of the organic material used in formation of such an anti-oxide film may be (3-mercaptopropyl)-trimethoxysilane. When the anti-oxide film is formed of SAM, a need for long-term dipping, complicated process conditions and increased rejection rates may occur, even though achieving increased antioxidative effects is possible.

The electronic component according to claim 1 comprises a metal surface coated with an anti-oxide film comprising a composition, which includes a perfluoropolyether (PFPE) derivative of formula (1) or (2):

**A-CF₂O(CF₂CF₂O)m(CF₂O)nCF₂-A** (1)

**CF₃O(CF₂CF₂O)m(CF₂O)nCF₂-A** (2)

wherein:
A is A' or RA' wherein A' is a functional group selected from the group consisting of COF, SiX₁X₂X₃ (X₁, X₂ and X₃ are independently C₁-C₁₀ alkyl and at least one of X₁, X₂ and X₃ is C₁-C₁₀ alkoxy), silanol, chlorosilane, carboxylic acid, alcohol, amine, phosphoric acid and derivatives thereof, and R is C₁-C₃₀ alkylene which may be optionally substituted by at least one selected from the group consisting of hydroxy, C₁-C₁₀ alkyl, hydroxyalkyl, amide, nitro, C₂-C₃₀ alkenyl, C₁-C₃₀ alkoxy, and C₂-C₃₀ alkoxyalkyl;
m is 1 to 50; and
n is 1 to 50; and
a PFPE-miscible polymer.

The aforesaid composition may be capable of inhibiting or retarding oxidation of a metal surface.

Described herein is an anti-oxide film including the composition and a metal surface and an electronic component including the anti-oxide film. Also described herein is a method of forming an anti-oxide film, which includes coating a metal surface with the above composition. Use of this method may allow for formation of an anti-oxide film via a solution treatment process. Also described herein is a method of manufacturing an electronic component including the method of forming the anti-oxide film.

Example embodiments will be more clearly understood from the following detailed description taken in conjunction with the accompanying drawings. FIGS. 1-3 represent non-limiting, example embodiments as described herein.
FIG. 1 is an example schematic process flow chart illustrating a method of forming an anti-oxide film;
FIG. 2 is an SEM image illustrating Au wiring on a wiring board with formation of an anti-oxide film against copper oxidation in Experimental Example 1; and
FIG. 3 is a graph illustrating comparison of process fraction defective (%) of Au wiring in Experimental Examples 1 and 2 and Comparative Experimental Example 1.

It should be noted that these Figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. For example, the relative thicknesses and positioning of molecules, layers, regions and/or structural elements may be reduced or exaggerated for clarity. The use of similar or identical reference numbers in the various drawings is intended to indicate the presence of a similar or identical element or feature.

Hereinafter, a detailed description will be given of example embodiments with reference to the accompanying drawings. In the drawings, the thicknesses of layers and regions are exaggerated for clarity, and the same reference numerals in the drawings denote the same element.

It will be understood that when an element or layer is referred to as being "on," "interposed," "disposed," or "between" another element or layer, it can be directly on, interposed, disposed, or between the other element or layer or intervening elements or layers may be present.

It will be understood that, although the terms first, second, third, and the like may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, first element, component, region, layer or section discussed below could be termed second element, component, region, layer or section without departing from the teachings of the example embodiments.

As used herein, the singular forms "a," "an" and "the" are intended to comprise the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Like numbers indicate like elements throughout. As used herein the term "and/or" includes any and all combinations of one or more of the associated listed items.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which these example embodiments belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The composition may maximize or increase antioxidative effects due to improved water repellency and diffusion barrier effects via the incorporation of the perfluoropolyether.

A weight-average molecular weight of perfluoropolyether may be in the range of about 1,000 to about 20,000. An example of perfluoropolyether of formula (1) may be a compound of formulas (3), (4) or (5):

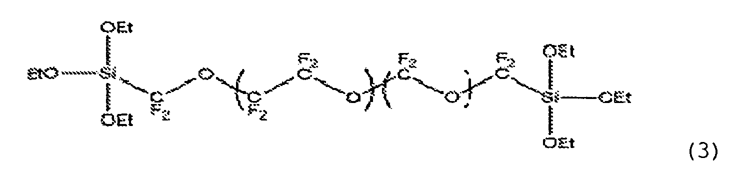

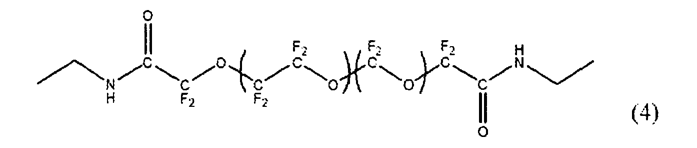

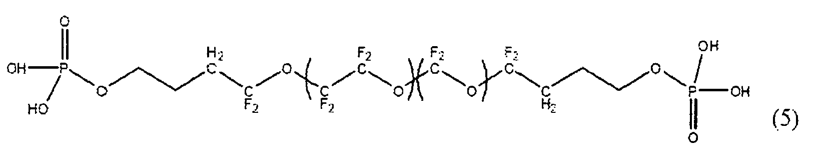

The perfluoropolyether and PFPE-miscible polymer may be used in the form of a mixture or copolymer thereof.

The photosensitive polymer is a water-soluble photosensitive polymer which is at least one selected from the group consisting of polyvinyl alcohol, polyvinyl chloride, polyacrylic amide, polyethylene glycol, polyethylene oxide, polymethylvinylether, polyethyleneimine, polyphenylenevinylene, polyaniline, polypyrrole and copolymers thereof.The PFPE-miscible polymer may have a weight-average molecular weight of about 500 to about 1,000,000, for example, about 20,000 to about 100,000.

A volume ratio of perfluoropolyether:PFPE-miscible polymer in the composition may be in the range of about 15:85 to about 1:99. If a content of perfluoropolyether is relatively high, decreased crosslinkability may result. On the other hand, if a content of perfluoropolyether is relatively low, deterioration in the hydrophobicity and diffusion barrier properties of the resulting thin film may result.

The anti-oxide film-forming composition may further include a photocuring agent. The photocuring agent may be added to accelerate curing of the coating film by UV irradiation. There may be no particular limit to types of the photocuring agent that may be used herein, for example, ammonium dichromate, pentaerythritol triacrylate, and urethane acrylate. These materials may be used alone or in any combination thereof. The photocuring agent may be added to the PFPE-miscible polymer dissolved in deionized water, in a ratio of about 0.005:1 to about 0.05:1, for example, about 0.01:1 to about 0.04:1, based on a content of solids.

In addition to aforesaid essential components, the film-forming composition may further include compatible polymers or various additives, for example, colorants, plasticizers, surfactants, and coupling agents, if necessary. These materials may be used alone or in any combination thereof.

The composition may be applied to at least one metal surface selected from the group consisting of copper, aluminum, iron, and molybdenum. Further, the composition may be capable of achieving formation of patterns by the solution process and may provide higher antioxidative effects in conjunction with suitability to subsequent processing including Au wiring.

In accordance with the invention the anti-oxide film includes the composition and a metal surface. In accordance with the invention the electronic component includes the anti-oxide film.

In accordance with the invention, a method of forming an anti-oxide film may be provided, which includes coating a metal surface with a composition containing the perfluoropolyether in conjunction with the PFPE-miscible polymer. The method may further include exposure of the coating film to UV irradiation, followed by development, after coating of the composition is complete. Hereinafter, the method of forming an anti-oxide film will be described in more detail.

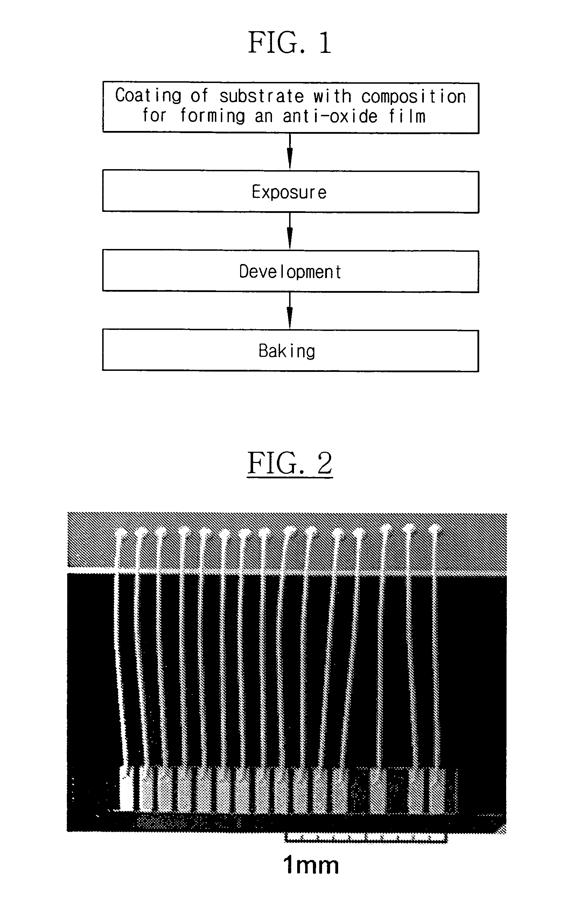

FIG. 1 is a schematic process flow chart illustrating a method of forming an anti-oxide film. Referring to FIG. 1, the film-forming method may be carried out by coating a metal surface with the anti-oxide film-forming composition to form a coating film, selectively exposing the resulting coating film through a mask, and developing the coating film with a developing solution to form an anti-oxide film. A baking step may also optionally be carried out.

Formation of the coating film may be carried out by a conventional method known in the art, e.g., spin coating, dip coating, casting, microgravure coating, gravure coating, bar coating, roll coating, wire bar coating, spray coating, screen printing, flexographic printing, offset printing, and inkjet printing. Examples of the solvent used in formation of the coating film from the anti-oxide film-forming composition may include water, alcohol, toluene, xylene, chloroform, and tetrahydrofuran.

Formation of the coating film may be followed by drying, UV irradiation and development. Drying may be carried out by any conventional method known in the art. Exposure of the coating film may be carried out through a mask. There may be no particular limit to the light source for exposure of the coating film, as long as the light source may be capable of photosensitizing photosensitive functional group(s) of the photosensitive polymer used. For example, UV light, X-ray, E-beam, excimer laser (F2, ArF, or KrF laser), or a high-pressure mercury lamp may be used as a light source. Exposure energy may be appropriately determined by structures of the photosensitive functional groups of the photosensitive polymer and energy types of the light sources. For example, exposure of the coating film may be carried out by UV irradiation at a wavelength of about 340 to about 400 nm for about 10 to about 180 seconds, using a UV lamp with power of about 300 to about 500W.

There may be no particular limit to the developing solution, as long as the solution imparts a sufficient difference in the solubility between the unexposed region and the exposed region. Water or a mixed solution of water with a water-compatible organic solvent may be used as a solvent for dissolution of the unexposed region of the photosensitive polymer. Non-limiting examples of the water-compatible organic solvent may include acetone, lower alcohol (e.g., methanol), acetonitrile and ketone (e.g., tetrahydrofuran). The developing solution may be a mixed solution.

When using the anti-oxide film-forming composition containing the water-soluble photosensitive polymer, deionized water may be used in the development step after completion of UV irradiation. For example, the development of the film may be carried out at about room temperature for about 1 to about 5 minutes, using deionized water.

After completion of the development, baking of the coating film may be carried out, if necessary. There may be no particular limit to the baking conditions. For example, the baking process may be carried out on a hot plate at a temperature of about 50 to about 150°C for about 0.5 to about 2 hours.

In accordance with the invention, there is provided a method of manufacturing an electronic component including forming the anti-oxide film which includes coating of the above composition. The electronic component is selected from wiring pads of memory and processing microdevices, optical sensors, heat sinks for display devices, wirings and electrodes of Organic Thin Film Transistors, electrodes of display devices, and wirings and electrodes of battery devices.

A better understanding of example embodiments will be described in more detail with reference to the following examples. However, these examples may be given for the purpose of illustration merely and may be not to be construed as limiting the scope of example embodiments.

### EXAMPLES

### Example 1: Preparation of Composition

Polyvinyl alcohol (about 0.5 wt% in Di-water, Kanto Chemical Co., Ltd.) was mixed with ammonium dichromate (Sigma Aldrich) in a weight ratio of about 1:0.03, based on a content of solids. The resulting mixture and a perfluoropolyether-phosphate derivative (PT5045, Solvay Solexis) were mixed in a volume ratio of about 99:1 and stirred to prepare a composition.

### Example 2: Preparation of Composition

A composition was prepared in the same manner as in Example 1, except that the mixture of polyvinyl alcohol (about 0.5 wt% in Di-water, Kanto Chemical Co., Ltd.) with ammonium dichromate (Sigma Aldrich) of Example 1 and a perfluoropolyether-phosphate derivative (PT5045, Solvay Solexis) were mixed in a volume ratio of about 97:3.

### Example 3: Preparation of Anti-oxide film against Oxidation of Copper

The anti-oxide film-forming composition synthesized in Example 1 was diluted to about 1/10 in water, coated on a copper metal substrate by spin coating at about 2000 rpm and dried at room temperature for about 15 minutes. A mask was placed on the dried surface of the coating film which was then irradiated with a 400 W/cm³ UV lamp at a wavelength of about 340 to about 400 nm for about 20 seconds and developed in deionized water at room temperature for about 3 minutes. As a result, only the UV-irradiated part remained in conjunction with dissolution of the unirradiated part to thereby result in the formation of patterns at the desired regions. Then, the coating was baked on a hot plate at a temperature of about 110°C for about 30 minutes to form an anti-oxide film with a thickness of about 2,000Å.

### Example 4: Preparation of Anti-oxide film against Oxidation of Copper

An anti-oxide film-forming composition synthesized in Example 1 was diluted to about 1/5 in water, coated on a copper metal substrate by spin coating at about 2000 rpm and dried at room temperature for about 15 minutes. A mask was placed on the dried surface of the copper metal which was then irradiated with a 400 W/cm³ UV lamp at a wavelength of about 340 to about 400 nm for about 20 seconds and developed in deionized water at room temperature for about 3 minutes. As a result, only the UV-irradiated part remained in conjunction with dissolution of the unirradiated part to thereby result in the formation of patterns at the desired region. Then, the coating was baked on a hot plate at a temperature of about 110°C for about 30 minutes to form an anti-oxide film with a thickness of about 2000Å.

### Experimental Example 1

Au wiring involving melt-adhesion of an Au wire by frictional heat was made on a substrate pad with formation of an anti-oxide film against copper oxidation prepared in Example 3.

### Experimental Example 2

Analogously to the procedure of Experimental Example 1, Au wiring was made on a substrate pad with formation of an anti-oxide film against copper oxidation prepared in Example 4.

### Comparative Experimental Example 1

Analogously to the procedure of Experimental Example 1, Au wiring was made on a substrate pad with no formation of an anti-oxide film. A rejection rate for adhesion completeness of the Au wiring over time in Experimental Examples 1 and 2 and Comparative Experimental Example 1 was measured by the naked eye and conductivity.

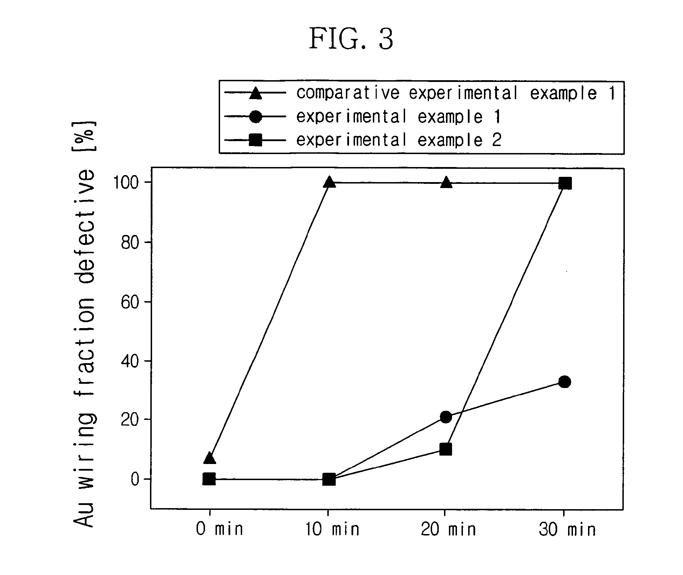

FIG. 2 is an SEM image illustrating Au wiring on a substrate pad with formation of an anti-oxide film against copper oxidation in Experimental Example 1. Referring to FIG. 2, a success rate of wiring may be higher when the substrate pad having the copper anti-oxide film is used. FIG. 3 is a graph illustrating comparison of process fraction defective (%) of Au wiring in Experimental Examples 1 and 2 and Comparative Experimental Example 1. Referring to FIG. 3, the substrate pad without formation of an anti-oxide film may exhibit an increase in a failure rate of Au wiring over time, whereas the substrate pad with formation of the anti-oxide film exhibits a decrease in a failure rate of Au wiring over time. Referring to FIGS. 2 and 3, the substrate pad having the anti-oxide film may be suited to subsequent processing including Au wiring.

Although example embodiments have been disclosed for illustrative purposes, those skilled in the art will appreciate that various modifications, additions and substitutions may be possible, without departing from the scope of claims 1-15.

## Claims

1. An electronic component comprising a metal surface coated with an anti-oxide film comprising a composition comprising a perfluoropolyether (PFPE) derivative of formula (1) or (2):
**A-CF₂O(CF₂CF₂O)m(CF₂O)nCF₂-A** (1)
**CF₃O(CF₂CF₂O)m(CF₂O)nCF₂-A** (2)
wherein:
A is A' or RA' wherein A' is a functional group selected from the group consisting of COF, SiX₁X₂X₃ (X₁, X₂ and X₃ are independently C₁-C₁₀ alkyl and at least one of X₁, X₂ and X₃ is C₁-C₁₀ alkoxy), silanol, chlorosilane, carboxylic acid, alcohol, amine, phosphoric acid, and R is C₁-C₃₀ alkylene which may be optionally substituted by at least one selected from the group consisting of hydroxy, C₁-C₁₀ alkyl, hydroxyalkyl, amide, nitro, C₂-C₃₀ alkenyl, C₁-C₃₀ alkoxy, and C₂-C₃₀ alkoxyalkyl;
m is 1 to 50; and
n is 1 to 50; and
a PFPE-miscible polymer, wherein the PFPE-miscible polymer is at least one water-soluble photosensitive polymer selected from the group consisting of polyvinyl alcohol, polyvinyl chloride, polyacrylic amide, polyethylene glycol, polyethylene oxide, polymethylvinylether, polyethyleneimine, polyphenylenevinylene, polyaniline, polypyrrole and copolymers thereof, wherein the electronic component is selected from wiring pads of memory and processing microdevices, optical sensors, heat sinks for display devices, wirings and electrodes of Organic Thin Film Transistors, electrodes of display devices, and wirings and electrodes of battery devices.

2. The electronic component of claim 1, wherein the perfluoropolyether derivative and PFPE-miscible polymer form a copolymer.

3. The electronic component of claim 1 or 2, wherein the perfluoropolyether of formula (1) is a compound selected from the group consisting of formula (3), (4) and (5):

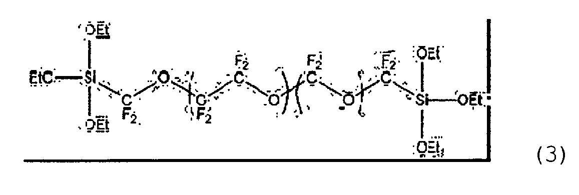

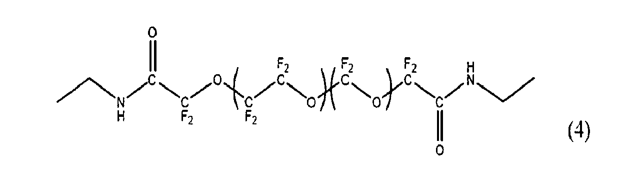

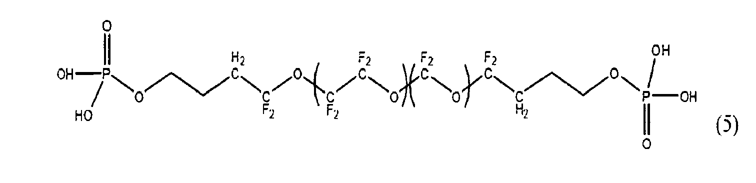

4. The electronic component of claim 1, wherein the weight-average molecular weight of perfluoropolyether is in the range of about 1,000 to about 20,000.

5. The electronic component of claim 1, wherein the PFPE-miscible polymer has a weight-average molecular weight of about 500 to about 1,000,000.

6. The electronic component of any of claims 1-5, wherein a volume ratio of the perfluoropolyether derivative:PFPE-miscible polymer in the composition is in the range of about 15:85 to about 1:99.

7. The electronic component of any of claims 1-6, the anti-oxide film further comprising:
a photocuring agent.

8. The electronic component of claim 7, wherein the composition includes the photocuring agent relative to the PFPE-miscible polymer in a ratio of about 0.005:1 to about 0.05:1, based on a content of solids.

9. The electronic component of claim 7 or 8, wherein the photocuring agent is at least one selected from the group consisting of ammonium dichromate, pentaerythritol triacrylate and urethane acrylate.

10. The electronic component of any of claims 1-9, wherein the metal of the metal surface is at least one selected from the group consisting of copper, aluminum, iron, and molybdenum.

11. A method of manufacturing an electronic component comprising a metal surface coated with an anti-oxide film, the method comprising
coating said metal surface with said anti-oxide film comprising a composition including a a perfluoropolyether (PFPE) derivative of formula (1) or (2):
**A-CF₂O(CF₂CF₂O)m(CF₂O)nCF₂-A** (1)
**CF₃O(CF₂CF₂O)m(CF₂O)nCF₂-A** (2)
wherein:
A is A' or RA' wherein A' is a functional group selected from the group consisting of COF, SiX₁X₂X₃ (X₁, X₂ and X₃ are independently C₁-C₁₀ alkyl and at least one of X₁, X₂ and X₃ is C₁-C₁₀ alkoxy), silanol, chlorosilane, carboxylic acid, alcohol, amine, phosphoric acid, and R is C₁-C₃₀ alkylene which may be optionally substituted by at least one selected from the group consisting of hydroxy, C₁-C₁₀ alkyl, hydroxyalkyl, amide, nitro, C₂-C₃₀ alkenyl, C₁-C₃₀ alkoxy, and C₂-C₃₀ alkoxyalkyl;
m is 1 to 50; and
n is 1 to 50; and
a PFPE-miscible polymer, wherein the PFPE-miscible polymer is at least one water-soluble photosensitive polymer selected from the group consisting of polyvinyl alcohol, polyvinyl chloride, polyacrylic amide, polyethylene glycol, polyethylene oxide, polymethylvinylether, polyethyleneimine, polyphenylenevinylene, polyaniline, polypyrrole and copolymers thereof, wherein the electronic component is selected from wiring pads of memory and processing microdevices, optical sensors, heat sinks for display devices, wirings and electrodes of Organic Thin Film Transistors, electrodes of display devices, and wirings and electrodes of battery devices.

12. The method of claim 11, wherein the metal of the metal surface is at least one selected from the group consisting of copper, aluminum, iron, and molybdenum.

13. The method of claim 11 or 12, wherein coating the metal surface is carried out by spin coating, dip coating, casting, microgravure coating, gravure coating, bar coating, roll coating, wire bar coating, spray coating, screen printing, flexographic printing, offset printing, or inkjet printing.

14. The method of any of claims 11-13, further comprising:
selectively exposing the coated film through a mask after coating the metal surface; and
developing the coating film.

15. The method of claim 14, wherein developing the coating film is carried out at room temperature for about 1 to about 5 minutes, using deionized water.

## Patentansprüche

1. Elektronisches Bauelement, das eine Metalloberfläche umfasst, die mit einem Antioxidfilm beschichtet ist, der eine Zusammensetzung umfasst, die Folgendes umfasst: ein Perfluorpolyether (PFPE)-Derivat der Formel (1) oder (2):
**A-CF₂O(CF₂CF₂O)ₘ(CF₂O)nCF₂-A** (1)
**CF₃O (CF₂CF₂O)m(CF₂O)nCF₂-A** (2),
worin:
A A' oder RA' ist, worin A' eine funktionelle Gruppe ist, die aus der Gruppe ausgewählt ist, die aus Folgenden besteht: COF, SiX₁X₂X₃ (X₁, X₂ und X₃ sind unabhängig C₁-C₁₀-Alkyl und mindestens eines von X₁, X₂ und X₃ ist C₁-C₁₀-Alkoxy), Silanol, Chlorsilan, Carbonsäure, Alkohol, Amin, Phosphorsäure, und R C₁-C₃₀-Alkylen ist, das optional durch mindestens eines substituiert sein kann, das aus der Gruppe ausgewählt ist, die aus Folgenden besteht: Hydroxy, C₁-C₁₀-Alkyl, Hydroxyalkyl, Amid, Nitro, C₂-C₃₀-Alkenyl, C₁-C₃₀-Alkoxy und C₂-C₃₀-Alkoxyalkyl;
m 1 bis 50 ist; und
n 1 bis 50 ist; und
ein mit PFPE mischbares Polymer, worin das mit PFPE mischbare Polymer mindestens ein wasserlösliches lichtempfindliches Polymer ist, das aus der Gruppe ausgewählt ist, die aus Folgenden besteht: Polyvinylalkohol, Polyvinylchlorid, Polyacrylamid, Polyethylenglycol, Polyethylenoxid, Polymethylvinylether, Polyethylenimin, Polyphenylenvinylen, Polyanilin, Polypyrrol und Copolymeren davon, worin das elektronische Bauelement aus Folgenden ausgewählt ist:
Verdrahtungsblöcken von Mikrospeicher- und - verabreitungsgeräten, optischen Sensoren, Kühlkörpern für Anzeigegeräte, Verdrahtungen und Elektroden von organischen Dünnfilmtransistoren, Elektroden von Anzeigegeräten und Verdrahtungen und Elektroden von Batteriegeräten.

2. Elektronisches Bauelement nach Anspruch 1, worin das Perfluorpolyether-Derivat und das mit PFPE mischbare Polymer ein Copolymer bilden.

3. Elektronisches Bauelement nach Anspruch 1 oder 2, worin der Perfluorpolyether der Formel (1) eine Verbindung ist, die aus der Gruppe ausgewählt ist, die aus den Formeln (3), (4) und (5) besteht:

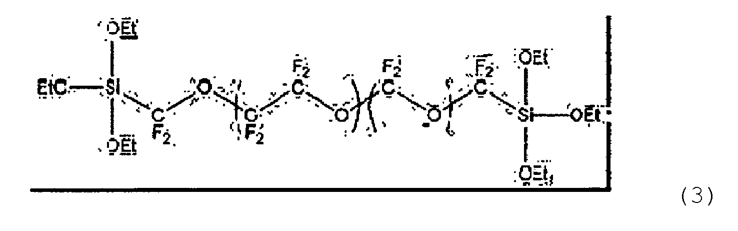

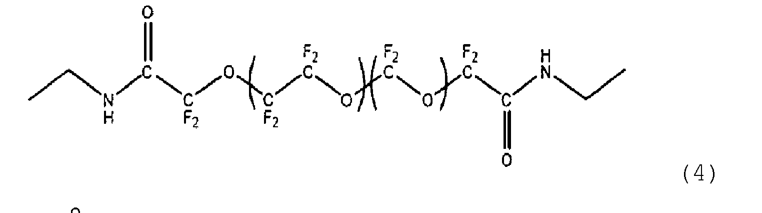

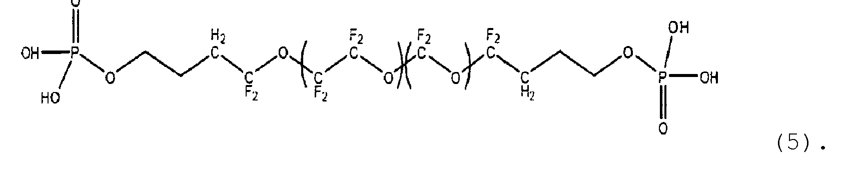

4. Elektronisches Bauelement nach Anspruch 1, worin das gewichtsmittlere Molekulargewicht von Perfluorpolyether im Bereich von etwa 1 000 bis etwa 20 000 liegt.

5. Elektronisches Bauelement nach Anspruch 1, worin das mit PFPE mischbare Polymer ein gewichtsmittleres Molekulargewicht von etwa 500 bis etwa 1 000 000 aufweist.

6. Elektronisches Bauelement nach einem der Ansprüche 1-5, worin ein Volumenverhältnis von Perfluorpolyether-Derivat : mit PFPE mischbarem Polymer in der Zusammensetzung im Bereich von etwa 15 : 85 bis etwa 1 : 99 liegt.

7. Elektronisches Bauelement nach einem der Ansprüche 1-6, wobei der Antioxidfilm weiter Folgendes umfasst:
ein Lichthärtungsmittel.

8. Elektronisches Bauelement nach Anspruch 7, worin die Zusammensetzung das Lichthärtungsmittel in Bezug auf das mit PFPE mischbare Polymer in einem Verhältnis von etwa 0,005 : 1 bis etwa 0,05 : 1, bezogen auf einen Gehalt an Feststoffen, einschließt.

9. Elektronisches Bauelement nach Anspruch 7 oder 8, worin das Lichthärtungsmittel mindestens eines ist, das aus der Gruppe ausgewählt ist, die aus Ammoniumdichromat, Pentaerythritoltriacrylat und Urethanacrylat besteht.

10. Elektronisches Bauelement nach einem der Ansprüche 1-9, worin das Metall der Metalloberfläche mindestens eines ist, das aus der Gruppe ausgewählt ist, die aus Kupfer, Aluminium, Eisen und Molybdän besteht.

11. Verfahren zur Herstellung eines elektronischen Bauelements, das eine Metalloberfläche umfasst, die mit einem Antioxidfilm beschichtet ist, wobei das Verfahren Folgendes umfasst:
Beschichten der genannten Metalloberfläche mit dem genannten Antioxidfilm, der eine Zusammensetzung umfasst, die Folgendes einschließt: ein Perfluorpolyether (PFPE)-Derivat der Formel (1) oder (2):
**A-CF₂O (CF₂CF₂O)m(CF₂O)nCF₂-A** (1)
**CF₃O (CF₂CF₂O)m(CF₂O) nCF₂-A** (2),
worin:
A A' oder RA' ist, worin A' eine funktionelle Gruppe ist, die aus der Gruppe ausgewählt ist, die aus Folgenden besteht: COF, SiX₁X₂X₃ (X₁, X₂ und X₃ sind unabhängig C₁-C₁₀-Alkyl und mindestens eines von X₁, X₂ und X₃ ist C₁-C₁₀-Alkoxy), Silanol, Chlorsilan, Carbonsäure, Alkohol, Amin, Phosphorsäure, und R C₁-C₃₀-Alkylen ist, das optional durch mindestens eines substituiert sein kann, das aus der Gruppe ausgewählt ist, die aus Folgenden besteht: Hydroxy, C₁-C₁₀-Alkyl, Hydroxyalkyl, Amid, Nitro, C₂-C₃₀-Alkenyl, C₁-C₃₀-Alkoxy und C₂-C₃₀-Alkoxyalkyl;
m 1 bis 50 ist; und
n 1 bis 50 ist; und
ein mit PFPE mischbares Polymer, worin das mit PFPE mischbare Polymer mindestens ein wasserlösliches lichtempfindliches Polymer ist, das aus der Gruppe ausgewählt ist, die aus Folgenden besteht:
Polyvinylalkohol, Polyvinylchlorid, Polyacrylamid, Polyethylenglycol, Polyethylenoxid, Polymethylvinylether, Polyethylenimin, Polyphenylenvinylen, Polyanilin, Polypyrrol und Copolymeren davon, worin das elektronische Bauelement aus Folgenden ausgewählt ist:
Verdrahtungsblöcken von Mikrospeicher- und - verabreitungsgeräten, optischen Sensoren, Kühlkörpern für Anzeigegeräte, Verdrahtungen und Elektroden von organischen Dünnfilmtransistoren, Elektroden von Anzeigegeräten und Verdrahtungen und Elektroden von Batteriegeräten.

12. Verfahren nach Anspruch 11, worin das Metall der Metalloberfläche mindestens eines ist, das aus der Gruppe ausgewählt ist, die aus Kupfer, Aluminium, Eisen und Molybdän besteht.

13. Verfahren nach Anspruch 11 oder 12, worin das Beschichten der Metalloberfläche durch Folgendes ausgeführt wird: Schleuderbeschichtung, Tauchbeschichtung, Vergießen, Mikrogravurbeschichtung, Gravurbeschichtung, Stabbeschichtung, Walzenbeschichtung, Drahtstabbeschichtung, Sprühbeschichtung, Siebdruck, Flexodruck, Offsetdruck oder Tintenstrahldruck.

14. Verfahren nach einem der Ansprüche 11-13, das weiter Folgendes umfasst:
selektives Belichten des beschichteten Films durch eine Maske nach dem Beschichten der Metalloberfläche; und
Entwickeln des Beschichtungsfilms.

15. Verfahren nach Anspruch 14, worin das Entwickeln des Beschichtungsfilms bei Raumtemperatur für etwa 1 bis etwa 5 Minuten unter Verwendung von deionisiertem Wasser ausgeführt wird.

## Revendications

1. Composant électronique comprenant une surface métallique revêtue d'un film anti-oxydant comprenant une composition comprenant un dérivé de perfluoropolyéther (PFPE) de la formule (1) ou (2) :
**A-CF₂O(CF₂CF₂O)m(CF₂O)nCF₂-A** (1)
**CF₃O(CF₂CF₂O)m(CF₂O)nCF₂-A** (2)
dans lequel :
A est A' ou RA', A' étant un groupe fonctionnel sélectionné dans le groupe consistant en COF, SiX₁X₂X₃ (X₁, X₂ et X₃ étant indépendamment un alkyle C₁-C₁₀ et au moins l'un de X₁, X₂ et X₃ étant un alkoxy C₁-C₁₀), silanol, chlorosilane, acide carboxylique, alcool, amine, acide phosphorique, et R étant un alkylène C₁-C₃₀ qui peut être éventuellement substitué par au moins un élément sélectionné dans le groupe consistant en hydroxy, alkyle C₁-C₁₀, hydroxyalkyle, amide, nitro, alcényle C₂-C₃₀, alkoxy C₁-C₃₀, et alkoxyalkyle C₂-C₃₀ ;
m est compris entre 1 et 50 ; et
n est compris entre 1 et 50 ; et
un polymère miscible avec le PFPE, le polymère miscible avec le PFPE étant au moins un polymère photosensible soluble dans l'eau sélectionné dans le groupe consistant en alcool polyvinylique, chlorure polyvinylique, amide polyacrylique, polyéthylène glycol, oxyde de polyéthylène, polyméthylvinyléther, polyéthylèneimine, polyphénylènevinylène, polyaniline, polypyrrole et leurs copolymères, dans lequel le composant électronique est sélectionné parmi des plages de câblage de mémoire et des microdispositifs de traitement, des capteurs optiques, des dissipateurs thermiques pour dispositifs d'affichage, des câbles et électrodes de Transistors à Couches Minces Organiques, des électrodes de dispositifs d'affichage, et des câblages et électrodes de dispositifs de batterie.

2. Composant électronique selon la revendication 1, dans lequel le dérivé de perfluoropolyéther et le polymère miscible avec le PFPE forment un copolymère.

3. Composant électronique selon la revendication 1 ou 2, dans lequel le perfluoropolyéther de la formule (1) est un composé sélectionné dans le groupe de la formule (3), (4) et (5) :

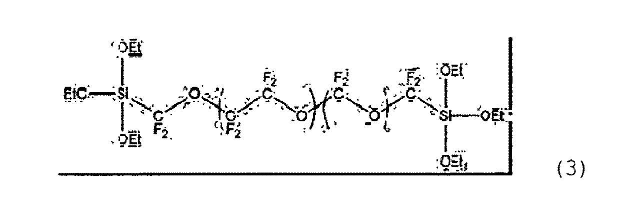

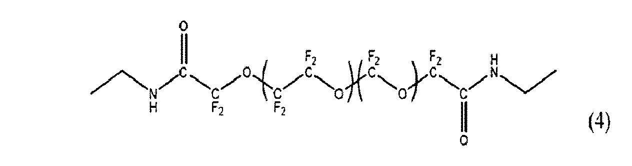

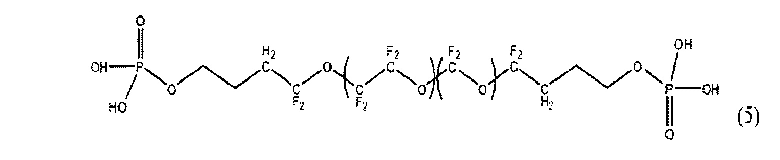

4. Composant électronique selon la revendication 1, dans lequel le poids moléculaire moyen en poids du perfluoropolyéther est compris dans la gamme d'environ 1 000 à environ 20 000.

5. Composant électronique selon la revendication 1, dans lequel le polymère miscible avec le PFPE a un poids moléculaire moyen en poids d'environ 500 à environ 1 000 000.

6. Composant électronique selon l'une quelconque des revendications 1 à 5, dans lequel un rapport volumique du dérivé de perfluoropolyéther:polymère miscible avec le PFPE dans la composition est compris dans la gamme d'environ 15:85 à environ 1:99.

7. Composant électronique selon l'une quelconque des revendications 1 à 6, le film anti-oxydant comprenant en outre :
un agent durcissant par effet photochimique.

8. Composant électronique selon la revendication 7, dans lequel la composition comporte l'agent durcissant par effet photochimique relativement au polymère miscible avec le PFPR dans un rapport d'environ 0,005:1 à 0,05:1, basé sur un contenu de solides.

9. Composant électronique selon la revendication 7 ou 8, dans lequel l'agent durcissant par effet photochimique est au moins un agent sélectionné dans le groupe consistant en dichromate d'ammonium, triacrylate de pentaérythritol, et acrylate d'uréthane.

10. Composant électronique selon l'une quelconque des revendications 1 à 9, dans lequel le métal de la surface métallique est au moins un métal sélectionné dans le groupe consistant en cuivre, aluminium, fer et molybdène.

11. Procédé de fabrication d'un composant électronique comprenant une surface métallique revêtue d'un film anti-oxydant, le procédé comprenant
le revêtement de ladite surface métallique avec ledit film anti-oxydant comprenant une composition comportant un dérivé de perfluoropolyéther (PFPE) de la formule (1) ou (2) :
**A-CF₂O(CF₂CF₂O)m(CF₂O)nCF₂-A** (1)
**CF₃O(CF₂CF₂O)m(CF₂O)nCF₂-A** (2)
dans lequel
A est A' ou RA', A' étant un groupe fonctionnel sélectionné dans le groupe consistant en COF, SiX₁X₂X₃ (X₁, X₂ et X₃ étant indépendamment un alkyle C₁-C₁₀ et au moins l'un de X₁, X₂ et X₃ étant un alkoxy C₁-C₁₀), silanol, chlorosilane, acide carboxylique, alcool, amine, acide phosphorique, et R étant un alkylène C₁-C₃₀ qui peut être éventuellement substitué par au moins un élément sélectionné dans le groupe consistant en hydroxy, alkyle C₁-C₁₀, hydroxyalkyle, amide, nitro, alcényle C₂-C₃₀, alkoxy C₁-C₃₀, et alkoxyalkyle C₂-C₃₀ ;
m est compris entre 1 et 50 ; et
n est compris entre 1 et 50 ; et
un polymère miscible avec le PFPE, le polymère miscible avec le PFPE étant au moins un polymère photosensible soluble dans l'eau sélectionné dans le groupe consistant en alcool polyvinylique, chlorure polyvinylique, amide polyacrylique, polyéthylène glycol, oxyde de polyéthylène, polyméthylvinyléther, polyéthylèneimine, polyphénylènevinylène, polyaniline, polypyrrole et leurs copolymères, dans lequel le composant électronique est sélectionné parmi des plages de câblage de mémoire et des microdispositifs de traitement, des capteurs optiques, des dissipateurs thermiques pour dispositifs d'affichage, des câbles et électrodes de Transistors à Couches Minces Organiques, des électrodes de dispositifs d'affichage, et des câblages et électrodes de dispositifs de batterie.

12. Procédé selon la revendication 11, dans lequel le métal de la surface métallique est au moins un métal sélectionné dans le groupe consistant en cuivre, aluminium, fer et molybdène.

13. Procédé selon la revendication 11 ou 12, dans lequel le revêtement de la surface métallique est effectué par application à la tournette, revêtement par immersion, coulée, revêtement par microimpression, revêtement par impression, revêtement à la lame, revêtement au rouleau, revêtement à la lame métallique, revêtement par pulvérisation, sérigraphie, impression flexographique, impression offset ou impression à jet d'encre.

14. Procédé selon l'une quelconque des revendications 11 à 13, comprenant en outre :
l'exposition sélective du film revêtu à travers un masque après le revêtement de la surface métallique ; et
le développement du film de revêtement.

15. Procédé selon la revendication 14, dans lequel le développement du film de revêtement est exécuté à température ambiante pendant environ 1 à environ 5 minutes, en utilisant de l'eau déminéralisée.
